# EUROPÄISCHE PATENTANMELDUNG

(11) **EP 3 618 255 A1**
(43) Veröffentlichungstag der Anmeldung: **04.03.2020**
(21) Anmeldenummer: 19192495.0
(22) Anmeldetag: 20.08.2019
(51) Int. Cl.: H02M 7/00, G01R 31/12, G01R 31/14, G01R 31/58

(54) **SCHALTEINRICHTUNG ZUM SCHALTEN VON HOCHSPANNUNGEN ZUR KABELPRÜFUNG DURCH BEAUFSCHLAGUNG EINES KABELPRÜFLINGS MIT DER HOCHSPANNUNG UND ENTLAGUNG DES KABELPRÜFLINGS**

(30) Priorität: 29.08.2018 DE 102018121048
(71) Anmelder: Hagenuk KMT Kabelmesstechnik GmbH, 01471 Radeburg (DE)
(72) Erfinder: Scheuschner, Sven, 01471 Radeburg (DE); Gründel, Melanie, 01471 Radeburg (DE)
(74) Vertreter: Kailuweit & Uhlemann Patentanwälte Partnerschaft mbB

(57) **Zusammenfassung**

Die Erfindung betrifft Schalteinrichtungen zum Schalten von Hochspannungen zur Kabelprüfung durch Beaufschlagung eines Kabelprüflings mit der Hochspannung und zur Entladung des Kabelprüflings, wobei wenigstens eine Einrichtung zum Schalten einer Hochspannung mit einer negativen Hochspannungsquelle und wenigstens eine gleich ausgebildete Einrichtung zum Schalten einer Hochspannung mit einer positiven Hochspannungsquelle verbunden sind. Diese zeichnen sich insbesondere dadurch aus, dass eine erhöhte Spannung mit einem Halbleiterschalter schaltbar ist. Dazu sind wenigstens ein elektrisch leitender Kühlkörper mit wenigstens einer Leiterplatte mit wenigstens einem Halbleiterschalter elektrisch isoliert in einem Gehäuse angeordnet. Die Leiterplatte ist ein wärmeleitender Isolator zwischen dem Halbleiterschalter und dem Kühlkörper, der mit einem Kühlmittel angeströmt und/oder durchströmt wird. Eine Leiterbahn ist mit einem Lastanschluss des Halbleiterschalters und einem ersten Spannungspotential verbunden. Weiterhin ist ein elektrisch leitende Bereich des Gehäuses mit einem zweiten Spannungspotential verbunden. Zwischen den Spannungspotentialen ist ein Spannungsteiler mit einem mit dem Kühlkörper verbundenen Zwischenspannungspotential geschalten.

## Beschreibung

Die Erfindung betrifft Schalteinrichtungen zum Schalten von Hochspannungen zur Kabelprüfung durch Beaufschlagung eines Kabelprüflings mit der Hochspannung und zur Entladung des Kabelprüflings, wobei wenigstens eine Einrichtung zum Schalten einer Hochspannung mit einer negativen Hochspannungsquelle und wenigstens eine gleich ausgebildete Einrichtung zum Schalten einer Hochspannung mit einer positiven Hochspannungsquelle verbunden sind.

Die auftretende Verlustleistung von Halbleiterschaltern in Einrichtungen zum Schalten hoher Spannungen muss zwingend abgeführt werden, da die Halbleiterschalter ansonsten zerstört werden. Dazu werden bekannte Kühlkörper verwendet, die die aus der Verlustleistung resultierende Wärme ableiten und an die Umgebung abgeben. Eine derartige passive Kühlung kann auch als aktive Kühlung ausgeführt sein, wobei ein Medienstrom am und/oder im Kühlkörper verwendet wird. Als Wärmeträger und damit Kühlmedien können dazu Luft und Wasser eingesetzt werden. Die dazu eingesetzten Kühlkörper insbesondere aus einem Metall wie Aluminium sind bekannt. Zur Vergrößerung der Kühlfläche können diese bekannterweise Strukturen wie beispielsweise Rippen aufweisen.

Durch die Druckschrift WO 99/39 428 A1 (AU 2 144 699 A) ist ein Leistungswandler mit Bipolartransistoren mit isoliertem Gate (IGBT) in Form mindestens eines IGBT-Moduls bekannt, wobei der Leistungswandler als Wechselrichter zur variablen Drehzahlregelung von Synchron- oder Asynchronmaschinen vorgesehen ist. Ein IGBT-Modul besitzt mehrere IGBT's, die auf einer Basis angeordnet sind. Weiterhin ist eine Modulisolation vorhanden, die ein Bestandteil des IGBT-Moduls ist. Diese IGBT-Module sind an der Kühleinheit befestigt. Außerhalb des IGBT-Moduls ist eine zusätzliche Isolierung zwischen (Kühl-) Rippen und der Kühleinheit vorgesehen. Der Leistungswandler besitzt die Kühleinheit, die über die Isolierung mit den Kühlrippen verbunden ist, welche auf dem Potential 0 liegen. Diese Kühlrippen dienen der Wärmeabfuhr. Weiterhin sind zwischen den IGBT's die Basis und die Isolierung vorhanden. Damit umfasst der Leistungswandler die IGBT-Module als Verlustleistungserzeuger, eine Modulisolation als einen ersten Thermowiderstand, eine erste Kühlkomponente als Wärmerohr, eine Isolation als einen zweiten Thermowiderstand und die Kühlrippen als zweite Kühlkomponente.

Die Druckschrift YAMAMOTO, Takuya; YOSHIWATARI, Shinichi; ICHIKAWA, Hiroaki. Expanded Lineup of High-Power 6 th Generation IGBT Module Families. Fuji Electric Review, 2012, 58. Jg., Nr. 2, S. 60-64) zeigt eine konkrete Ausgestaltung eines IGBT-Moduls mit einer Leiterplatte, deren Leiterbahn mit einem Lastanschluss des Halbleiterschalters und einem ersten Spannungspotential verbunden ist.

Der im Patentanspruch 1 angegebenen Erfindung liegt die Aufgabe zugrunde, die mit einem Halbleiterschalter schaltbare Spannung gekoppelt mit der abführbaren Verlustleistung zu erhöhen.

Diese Aufgabe wird mit den im Patentanspruch 1 aufgeführten Merkmalen gelöst.

Die Schalteinrichtungen zum Schalten von Hochspannungen zur Kabelprüfung durch Beaufschlagung eines Kabelprüflings mit der Hochspannung und zur Entladung des Kabelprüflings, wobei wenigstens eine Einrichtung zum Schalten einer Hochspannung mit einer negativen Hochspannungsquelle und wenigstens eine gleich ausgebildete Einrichtung zum Schalten einer Hochspannung mit einer positiven Hochspannungsquelle verbunden sind, zeichnen sich insbesondere dadurch aus, dass eine erhöhte Spannung mit einem Halbleiterschalter schaltbar ist, der zusätzlich eine sehr hohe und zwingend abführbare Verlustleistung aufweist.

Dazu sind wenigstens ein elektrisch leitender Kühlkörper mit wenigstens einer Leiterplatte mit wenigstens einem Halbleiterschalter elektrisch isoliert in einem wenigstens bereichsweise elektrisch leitenden Gehäuse der Einrichtung zum Schalten einer Hochspannung angeordnet. Die Leiterplatte ist ein Isolator zwischen dem Halbleiterschalter und dem Kühlkörper. Eine Leiterbahn der Leiterplatte ist mit einem Lastanschluss des Halbleiterschalters und einem ersten Spannungspotential verbunden. Weiterhin ist der elektrisch leitende Bereich des Gehäuses mit einem zweiten Spannungspotential verbunden. Zwischen dem ersten Spannungspotential und dem zweiten Spannungspotential ist ein Spannungsteiler geschalten. Darüber hinaus ist ein Zwischenspannungspotential des Spannungsteilers mit dem Kühlkörper verbunden.

Die Einrichtungen zum Schalten einer Hochspannung können insbesondere vorteilhafterweise in Kabelprüfgeräten als Schalter verwendet werden. Diese zeichnen sich durch die sehr hohe abführbare Verlustleistung und damit durch eine signifikante Leistungssteigerung gegenüber Schaltern aus, bei denen die Hochspannung über einen in einem wärmeleitenden Verguss isolierten Halbleiterschalter geschalten werden. Die Wärmeleitfähigkeit solcher Vergüsse ist kleiner als die Wärmeleitfähigkeit einer Leiterplatte, die insbesondere ein wärmeleitender Isolator zwischen dem Halbleiterschalter und dem Kühlkörper ist. Mit diesen Einrichtungen zum Schalten einer Hochspannung können demzufolge längere Kabelstrecken geprüft werden. Gleichzeitig reduziert sich die Prüfzeit eines Kabels, welches insbesondere bei einer dreiphasigen Prüfung wirksam wird.

Dabei umfasst die Einrichtung zum Schalten einer Hochspannung die diskreten IGBT's als Verlustleistungserzeuger, eine Keramikleiterplatte als einen Thermowiderstand und einen Kühlkörper als eine Kühlkomponente. Die Keramikleiterplatte ist ein Träger mit Leiterbahnen zur elektrischen Verbindung mit allen leistungselektronischen Bauelementen in Form der IGBT's, der zugehörigen Schutzbauelemente und der zugehörigen Steuerbauelemente als Bestückung der Leiterplatte. Der Kühlkörper kann mit einem Kühlmittel angeströmt und/oder durchströmt werden.

Vorteilhafte Ausgestaltungen der Erfindung sind in den Patentansprüchen 2 bis 10 angegeben.

Die Leiterplatte besteht nach der Weiterbildung des Patentanspruchs 2 aus einem Material mit einer hohen Wärmeleitfähigkeit, so dass eine gute Wärmeleitung vom Halbleiterschalter zum Kühlkörper vorhanden ist. Damit ist eine große Verlustleistungsabfuhr gegeben.

Das Gehäuse weist nach der Weiterbildung des Patentanspruchs 3 wenigstens einen Strömungskanal eines Kühlmittels auf, wobei ein Bereich des Kühlkörpers ein Bestandteil des Strömungskanals ist. Das Strömungsmedium im Strömungskanal kann insbesondere Luft oder Öl sein, so dass eine erzwungene Konvektion vorhanden ist.

Der Kühlkörper besitzt nach der Weiterbildung des Patentanspruchs 4 wenigstens einen Strömungskanal eines Kühlmittels. Das Strömungsmedium im Strömungskanal kann insbesondere Luft oder Öl sein, so dass eine erzwungene Konvektion vorhanden ist.

Nach der Weiterbildung des Patentanspruchs 5 sind das erste Spannungspotential das Spannungspotential der Hochspannungsquelle und das zweite Spannungspotential ein Bezugspotential.

Das Bezugspotential ist nach der Weiterbildung des Patentanspruchs 6 das Bezugspotential der Hochspannungsquelle und des Gehäuses in Verbindung mit dem Spannungsteiler.

Die Einrichtung ist nach der Weiterbildung des Patentanspruchs 7 ein Bestandteil einer Kaskade mit Einrichtungen. Die Möglichkeit einer Kaskadierung ermöglicht das Schalten verschiedener Spannungsreihen. Dabei kann eine Einrichtung als Gleichteil als Standardschalterbaugruppe in verschiedenen Geräten unterschiedlicher Nennspannung eingesetzt werden.

Der Halbleiterschalter weist nach der Weiterbildung des Patentanspruchs 8 wenigstens einen Bipolartransistor mit isolierter Gate-Elektrode (IGBT - insulated-gate bipolar transistor) oder einen Thyristor auf.

Die Leiterplatte besteht nach der Weiterbildung des Patentanspruchs 9 aus einer Keramik.

Jeweils wenigstens eine Einrichtung zum Schalten einer Hochspannung ist nach der Weiterbildung des Patentanspruchs 10 mit wenigstens einer Hochspannungsquelle verbunden. Damit können gewünschte Spannungsformen generiert werden. Die Einrichtungen dienen dabei insbesondere dem Abtransport der Verlustwärme von den Halbleiterschaltern und der elektrischen Isolierung der auf Hochspannungsniveau befindlichen Halbleiterschalter.

Ein Ausführungsbeispiel der Erfindung ist in den Zeichnungen jeweils prinzipiell dargestellt und wird im Folgenden näher beschrieben.

Es zeigen:
Fig. 1 eine Einrichtung zum Schalten einer Hochspannung mit Halbleiterschaltern mit angeströmten Kühlkörper,
Fig. 2 eine Einrichtung zum Schalten einer Hochspannung mit Halbleiterschaltern mit einem durchströmten Kühlkörper,
Fig. 3 eine Einrichtung zum Schalten einer Hochspannung mit Halbleiterschaltern mit durchströmten Kühlkörper mit mehreren Leiterplatten und
Fig. 4 eine Schalteinrichtung zum Schalten von Hochspannungen zur Kabelprüfung durch Beaufschlagung eines Kabelprüflings mit der Hochspannung und Entladung des Kabelprüflings.

Eine Einrichtung zum Schalten einer Hochspannung zur Verbindung mit wenigstens einer Hochspannungsquelle 7 besteht im Wesentlichen aus einem elektrisch leitenden Kühlkörper 1, einer Leiterplatte 2, wenigstens einem Halbleiterschalter 3, einem Gehäuse 4 und einem Spannungsteiler 5.

Dazu sind der elektrisch leitende Kühlkörper 1 mit der Leiterplatte 2 mit dem Halbleiterschalter 3 elektrisch isoliert in dem elektrisch leitenden Gehäuse 4 angeordnet. Die Leiterplatte 2 ist ein Isolator zwischen dem Halbleiterschalter 3 und dem Kühlkörper 1. Eine Leiterbahn 6 der Leiterplatte 2 ist mit einem Lastanschluss des Halbleiterschalters 3 und einem ersten Spannungspotential P1 verbunden. Das elektrisch leitende Gehäuse 4 ist mit einem zweiten Spannungspotential P2 verbunden. Zwischen dem ersten Spannungspotential P1 und dem zweiten Spannungspotential P2 ist der Spannungsteiler 5 geschalten. Dieser besteht wenigstens aus den Widerständen R1 und R2, die in Reihe geschalten sind. Das Zwischenspannungspotential P3 ist mit dem Kühlkörper 1 verbunden.

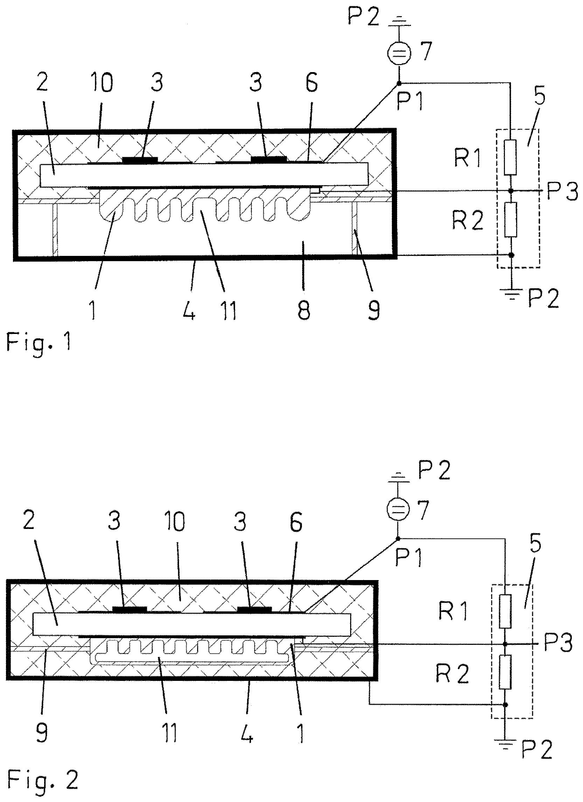

Die Fig. 1 zeigt eine Einrichtung zum Schalten einer Hochspannung mit Halbleiterschaltern 3 mit angeströmten Kühlkörper 1 in einer prinzipiellen Darstellung.

In einer ersten Ausführungsform ist die Einrichtung zum Schalten einer Hochspannung mit wenigstens einer Hochspannungsquelle 7 verbunden. Der Kühlkörper 1 mit der Leiterplatte 2 ist beabstandet zu wenigstens einer Wand des Gehäuses 4 im Gehäuse 4 angeordnet, so dass ein freier Raum 8 und damit ein Strömungskanal 11 ausgebildet ist. Dazu ist oder sind der Kühlkörper 1 und/oder die Leiterplatte 2 mittels wenigstens einem Halter 9 im Gehäuse 4 positioniert. Das Strömungsmedium im Strömungskanal 11 kann insbesondere Luft sein, wobei eine erzwungene Konvektion vorhanden ist. Das Gehäuse 4 besitzt dazu entsprechende Anschlüsse zum Eintritt und Austritt der Luft. Der auf Zwischenspannungspotential P3 liegende Kühlkörper 1 ist vom auf dem zweiten Spannungpotential P2 liegenden Gehäuse 4 durch Luft isoliert. Die Leiterplatte 2 und die in der Fig. 1 beispielsweise gezeigten zwei Halbleiterschalter 3 sind gegenüber dem aus einem Metall bestehenden Gehäuse 4 mit einer Vergussmasse 10 isoliert. Die Wärmeleitfähigkeit der Vergussmasse 10 spielt eine untergeordnete Rolle, da die maßgebliche Wärmeabfuhr über die Leiterplatte 2 aus einer Keramik, den Kühlkörper 1 und das strömende Kühlmedium erfolgt.

Die Fig. 2 zeigt eine Einrichtung zum Schalten einer Hochspannung mit Halbleiterschaltern 3 mit einem durchströmten Kühlkörper 1 in einer prinzipiellen Darstellung.

In einer zweiten Ausführungsform ist die Einrichtung zum Schalten einer Hochspannung mit wenigstens einer Hochspannungsquelle 7 verbunden. Der Kühlkörper 1 mit der Leiterplatte 2 ist beabstandet zu den Wänden des Gehäuses 4 im Gehäuse 4 angeordnet. Dazu ist der Kühlkörper 1 mit der Leiterplatte 2 mit dem Halter 9 im Gehäuse 4 positioniert. Der Kühlkörper 1 besitzt einen Strömungskanal 11 eines fluiden Mediums. Das kann insbesondere Luft sein, so dass eine erzwungene Konvektion vorhanden ist. Das Gehäuse 4 und/oder der Kühlkörper 1 besitzt dazu entsprechende Anschlüsse zum Eintritt und Austritt der Luft. Der auf Zwischenspannungspotential P3 liegende Kühlkörper 1, die Leiterplatte 2 und die in der Fig. 2 beispielhaft gezeigten Halbleiterschalter 3 sind vom auf dem zweiten Spannungspotential P2 liegenden Gehäuse 4 durch die Vergussmasse 10 isoliert. Die Wärmeleitfähigkeit der Vergussmasse 10 spielt eine untergeordnete Rolle, da die maßgebliche Wärmeabfuhr über die Leiterplatte 2 aus einer Keramik, den Kühlkörper 1 und des strömende Kühlmedium erfolgt.

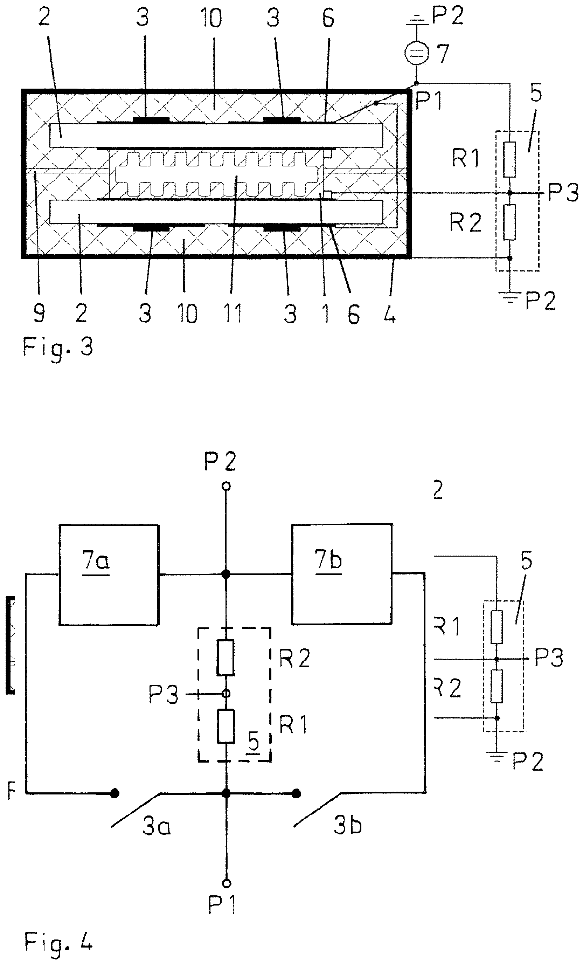

Die Fig. 3 zeigt eine Einrichtung zum Schalten einer Hochspannung mit Halbleiterschaltern 3 mit durchströmten Kühlkörper 1 mit mehreren Leiterplatten 2 in einer prinzipiellen Darstellung.

In einer dritten Ausführungsform ist die Einrichtung zum Schalten einer Hochspannung mit wenigstens einer Hochspannungsquelle 7 verbunden. Der Kühlkörper 1 dieser Ausführungsform weist gegenüber der zweiten Ausführungsform beidseitig angeordnete Leiterplatten 2 auf. Der Kühlkörper 1 mit den Leiterplatten 2 befindet sich mittels des Halters 9 beabstandet zu den Wänden des Gehäuses 4 im Gehäuse 4. Der Kühlkörper 1 mit den Leiterplatten 2 besitzt einen Strömungskanal 11 mit beidseitig vorhandenen Kühlrippen. Der auf Zwischenspannungspotential P3 liegende Kühlkörper 1, die Leiterplatten 2 und die Halbleiterschalter 3 sind vom auf dem zweiten Spannungspotential P2 liegenden Gehäuse 4 durch die Vergussmasse 10 isoliert.

Die Fig. 4 zeigt eine Schalteinrichtung zum Schalten von Hochspannungen zur Kabelprüfung durch Beaufschlagung eines Kabelprüflings mit der Hochspannung und Entladung des Kabelprüflings in einer prinzipiellen Darstellung.

Die Einrichtungen zum Schalten einer Hochspannung zur Verbindung mit wenigstens einer Hochspannungsquelle 7 können insbesondere zur Generierung einer gewünschten Spannungsform zur Kabelprüfung zur Beaufschlagung mit der Spannung und zur Entladung des Kabelprüflings verwendet werden. Dazu sind wenigstens zwei Einrichtungen zum Schalten einer Hochspannung mit einer negativen Hochspannungsquelle 7a und einer positiven Hochspannungsquelle 7b verbunden. Die Einrichtungen dienen dabei insbesondere dem Abtransport der Verlustwärme von den Halbleiterschaltern 3a, 3b und der elektrischen Isolierung der auf Hochspannungsniveau befindlichen Halbleiterschalter 3a, 3b.

### Bezugszeichen

- 1: Kühlkörper
- 2: Leiterplatte
- 3: Halbleiterschalter
- 4: Gehäuse
- 5: Spannungsteiler
- 6: Leiterbahn
- 7: Hochspannungsquelle
- 8: freier Raum im Gehäuse
- 9: Halter
- 10: Vergussmasse
- 11: Strömungskanal
- P1: erstes Spannungspotential
- P2: zweites Spannungspotential
- P3: Zwischenspannungspotential
- R1: Widerstand
- R2: Widerstand

## Patentansprüche

1. Schalteinrichtung zum Schalten von Hochspannungen zur Kabelprüfung durch Beaufschlagung eines Kabelprüflings mit der Hochspannung und Entladung des Kabelprüflings, wobei wenigstens eine Einrichtung zum Schalten einer Hochspannung mit einer negativen Hochspannungsquelle (7a) und wenigstens eine gleich ausgebildete Einrichtung zum Schalten einer Hochspannung mit einer positiven Hochspannungsquelle (7b) verbunden sind, **dadurch gekennzeichnet, dass** wenigstens ein elektrisch leitender Kühlkörper (1) mit wenigstens einer Leiterplatte (2) mit wenigstens einem Halbleiterschalter (3) elektrisch isoliert in einem wenigstens bereichsweise elektrisch leitenden Gehäuse (4) der Einrichtung zum Schalten einer Hochspannung angeordnet sind, dass die Leiterplatte (2) ein Isolator zwischen dem Halbleiterschalter (3) und dem Kühlkörper (1) ist, dass eine Leiterbahn (6) der Leiterplatte (2) mit einem Lastanschluss des Halbleiterschalters (3) und einem ersten Spannungspotential (P1) verbunden ist, dass der elektrisch leitende Bereich des Gehäuses (4) mit einem zweiten Spannungspotential (P2) verbunden ist, dass zwischen dem ersten Spannungspotential (P1) und dem zweiten Spannungspotential (P2) ein Spannungsteiler (5) geschalten ist und dass ein Zwischenspannungspotential (P3) des Spannungsteilers (5) mit dem Kühlkörper (1) verbunden ist.

2. Einrichtung nach Patentanspruch 1, **dadurch gekennzeichnet, dass** die Leiterplatte (2) aus einem Material mit einer hohen Wärmeleitfähigkeit besteht, so dass eine gute Wärmeleitung vom Halbleiterschalter (3) zum Kühlkörper (1) vorhanden ist.

3. Einrichtung nach Patentanspruch 1, **dadurch gekennzeichnet, dass** das Gehäuse (4) wenigstens einen Strömungskanal (11) eines Kühlmittels aufweist, wobei ein Bereich des Kühlkörpers (1) ein Bestandteil des Strömungskanals (11) ist.

4. Einrichtung nach Patentanspruch 1, **dadurch gekennzeichnet, dass** der Kühlkörper (1) wenigstens einen Strömungskanal (11) eines Kühlmittels besitzt.

5. Einrichtung nach Patentanspruch 1, **dadurch gekennzeichnet, dass** das erste Spannungspotential (P1) das Spannungspotential der Hochspannungsquelle (7) ist und dass das zweite Spannungspotential (P2) ein Bezugspotential ist.

6. Einrichtung nach den Patentansprüchen 1 und 5, **dadurch gekennzeichnet, dass** das Bezugspotential das Bezugspotential der Hochspannungsquelle (7) und des Gehäuses (4) in Verbindung mit dem Spannungsteiler (5) ist.

7. Einrichtung nach Patentanspruch 1, **dadurch gekennzeichnet, dass** die Einrichtung ein Bestandteil einer Kaskade mit Einrichtungen ist.

8. Einrichtung nach Patentanspruch 1, **dadurch gekennzeichnet, dass** der Halbleiterschalter (3) wenigstens einen Bipolartransistor mit isolierter Gate-Elektrode oder einen Thyristor aufweist.

9. Einrichtung nach den Patentansprüchen 1 und 2, **dadurch gekennzeichnet, dass** die Leiterplatte (2) aus einer Keramik besteht.

10. Einrichtung nach Patentanspruch 1, **dadurch gekennzeichnet, dass** jeweils wenigstens eine Einrichtung zum Schalten einer Hochspannung mit wenigstens einer Hochspannungsquelle (7) verbunden ist.
